# EUROPEAN PATENT SPECIFICATION

(11) **EP 1 517 777 B1**
(45) Date of publication and mention of the grant of the patent: **21.11.2018**
(21) Application number: 03740321.9
(22) Date of filing: 24.06.2003
(51) Int. Cl.: C08K 3/013, B29C 55/00, B29C 70/58

(54) **RADIATION SCREENING MATERIALS**
STRAHLUNGSABSCHIRMENDE MATERIALIEN
MATERIAUX FAISANT ECRAN AUX RAYONNEMENTS

(30) Priority: 02.07.2002 EP 02078294
(43) Date of publication of application: 30.03.2005
(73) Proprietor: INEOS Manufacturing Belgium NV, 2040 Antwerpen (BE)
(72) Inventor: LAMBERT, Yves-Julien, B-1325 Chaumont Gistoux (BE)
(74) Representative: Smith, Julian Philip Howard
(86) International application number: PCT/EP2003/006640
(87) International publication number: WO 2004/005011

(56) References cited:
- WO-A-94/05727
- US-A- 4 090 773

## Description

The present invention relates to materials for the screening of solar radiation, particularly to those materials typically used for influencing plant growth in greenhouses or similar enclosures.

In order to control the growth of plants, it is known that temperature, light intensity and spectral distribution of incoming light are critical factors. Furthermore, plants in a greenhouse will not grow so well if the variations in temperature between day and night are too large, as this causes them to develop resistance to the variations in temperature. Thus, for photosynthesis in greenhouses photosynthetically active radiation (PAR) is required, whilst at the same time it is preferred to block near infrared radiation in order to avoid excessive temperatures within the enclosed area. Furthermore it is desirable to scatter incoming radiation in order to prevent burning. Conversely, for outdoor mulch films the objective is to screen the photosynthetically active radiation whilst transmitting all other parts of the spectrum.

It is known to provide screening materials made of plastic for greenhouses so as to screen some of the incoming radiation. It is also known to provide for greenhouses glazing materials which contain an interference pigment to screen certain radiation. Hancock describes in "Plastic Culture", No. 79, 1988, pp. 4 to 14, that special additives in LDPE have a favourable effect on the microclimate in greenhouses because of the generation of diffuse light and the creation of a favourably thermic effect in the greenhouses. Suitable additives are aluminosilicate in the form of kaolin, calcium carbonate, talc and kaolin clay. DE-A-2544245 discloses a polymethyl methacrylate glazing material which contains an interference pigment for screening near infra- red radiation. However this pigment has the disadvantage that it does not transmit the ideal spectrum of radiation required by plants in a greenhouse.

EP-A-428,937 describes a grey-white coating composition for greenhouses consisting of a liquid polymeric carrier and reflecting particles suspended therein. These particles are aluminium platelets or mica platelets coated with titanium dioxide. The coating composition is used for temporary coatings in extreme weather conditions (summer). In winter, it can be removed by washing off with a water jet.

It is known to use nets made of plastic such as polyethylene as radiation screens. The nets are typically coated with a thin layer of aluminium to act as a reflector, which has been bonded to the polyethylene by sublimation or lamination prior to the polyethylene being cut into tapes and woven into nets. Alternatively the aluminium can be incorporated into the body of the polyethylene, although this gives poorer reflectivity. Generally nets are considered superior to solid sheets as radiation screens for greenhouses, as they are more flexible, have a higher tear strength, and also a higher tensile strength at yield and break.

EP-A-659,198 discloses a composite material for use as a radiation screen in greenhouses which is a material comprising a transparent polymer and a green interference pigment consisting of a platelet shaped material coated with one or more metal oxides, and is typically of 200µm thickness. This interference pigment only transmits the red and blue portions of visible light which can be utilised by the plant. The composite material may be in the form of sheets or woven fabrics. It is also stated that for optimum performance, the pigment platelets should be aligned parallel to the surface and to one another.

We have discovered that it is possible to increase the screening efficiency of radiation screens formed by incorporating a pigment within a plastic substrate, by stretching the substrate after incorporation of the pigment. Disclosed herein is a composition for screening solar radiation, which comprises
a transparent polymer having incorporated therein an interference pigment comprising a platelet shaped material,
wherein the polymer has been stretched in at least one direction to at least twice its original length in that direction after incorporation of the pigment coating.

Prior art sheets incorporating pigment are typically of the order of 100µm thick. Platelets of pigment are typically of the order of 15-50µm in length. Thus the platelets can be aligned in any direction. We have found that by stretching the material, the thickness of the material can be reduced to less than 50µm, typically less than 30µm, thereby forcing all the pigment platelets to lie flat, parallel to one another. This significantly improves the reflective power of the pigment.

An aspect of the invention provides a process for the production of a composition for screening solar radiation which comprises a transparent polymer incorporating a interference pigment comprising a platelet shaped material, which process comprises the steps of incorporating the interference pigment into the polymer, stretching the resultant polymer in at least one direction to at least twice its original length in that direction, and then converting the polymer into a woven net of tapes or monofilaments.

Preferably the degree of stretching of the material is to at least 4 times its original length; typically from 6 to 10 times, and most preferably 7 to 8 times.

Further disclosed herein is a composition for screening solar radiation, which comprises
a) a transparent polymer, and
b) an interference pigment comprising a platelet shaped material,
which composition is less than 50µm in thickness.

The transparent polymer is preferably selected from the group comprising low-density or high-density polyethylene, ethylene vinyl acetate copolymer, poly tetrafluoroethylene, ethylene tetrafluoroethylene, polyvinylidene chloride, polyvinylidene fluoride, polyvinyl chloride, polycarbonate, polymethacrylate or mixtures thereof. Other fluoropolymers may also be used.

The interference pigment can be a green interference pigment, which reflects purple and transmits green light, or a neutral pigment which provides simply a translucent film; although other types of pigment may be used.

The interference pigment is preferably a layered silicate, synthetic mica, glass platelets, ceramic platelets or silica platelets. Preferably the layered silicate is mica, pyrophillite, sericite, talc or kaolin. It may optionally contain other additives such as metal oxides, eg tin oxide SnO₂, titanium dioxide or zirconium dioxide.

The pigment content of the material of the invention is typically 0.1 to 30% by weight, preferably 0.5 to 10% by weight, based on the polymer.

The materials may additionally contain the usual stabilizers and processing aids employed with the particular polymer.

The material of the invention is formed into tapes or monofilaments which are then woven into nets. In a typical process the material is first compounded and then blown into a film, after which it is stretched, typically to 4-8 times its original dimension. The stretched film is then cut into tapes which are woven or knitted into nets. This is known as the Lenzing process. In an alternative process (the Iso process), the blown film is cut into tapes prior to stretching. Alternatively the material is extruded into monofilaments, which are then stretched prior to weaving.

Typically, the polymer utilised is fed into an extruder together with the pigment, and the mixture extruded to form a film. In an alternative embodiment, some of the polymer is compounded with a relatively high concentration (eg 30 wt%) of the pigment to form pellets, which are then introduced into an extruder together with additional pure polymer. Where a blown film is required, the polymer exits the extruder via a circular die, and the film is blown from a nozzle in the centre of the die. For flat films, the polymer exits the extruder via a flat die. Flat films are generally thicker than blown films.

Typically the film is then stretched at this stage. Stretching is usually carried out in an oven or on a hot plate at a temperature of 100-110°C, at a stretch ratio preferably between 7 and 8 for blown films, and 4 to 6 for flat films. Optionally the stretched film may then be annealed.

If it is desired to make nets, the film is slit into tapes, which are knitted or woven into a net.

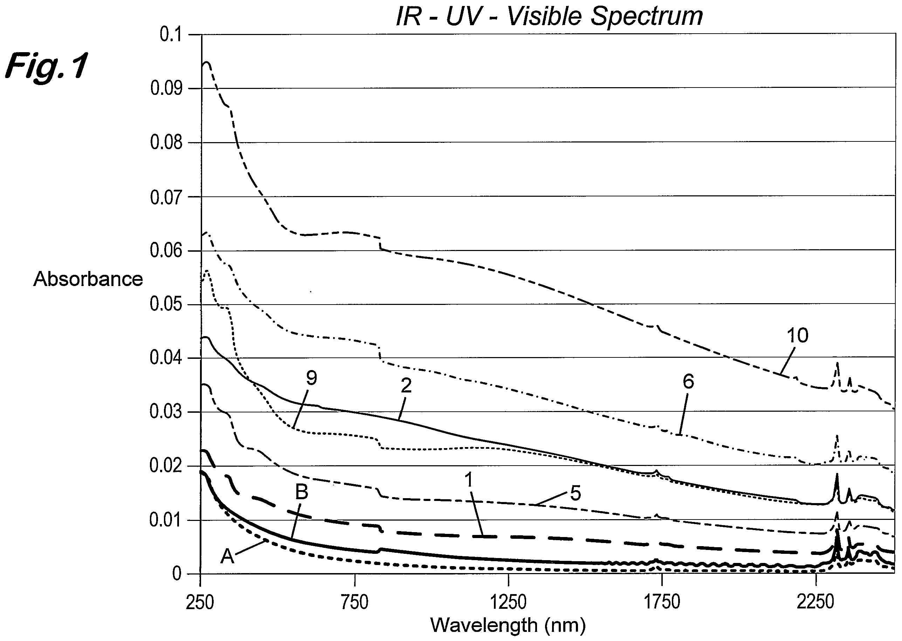

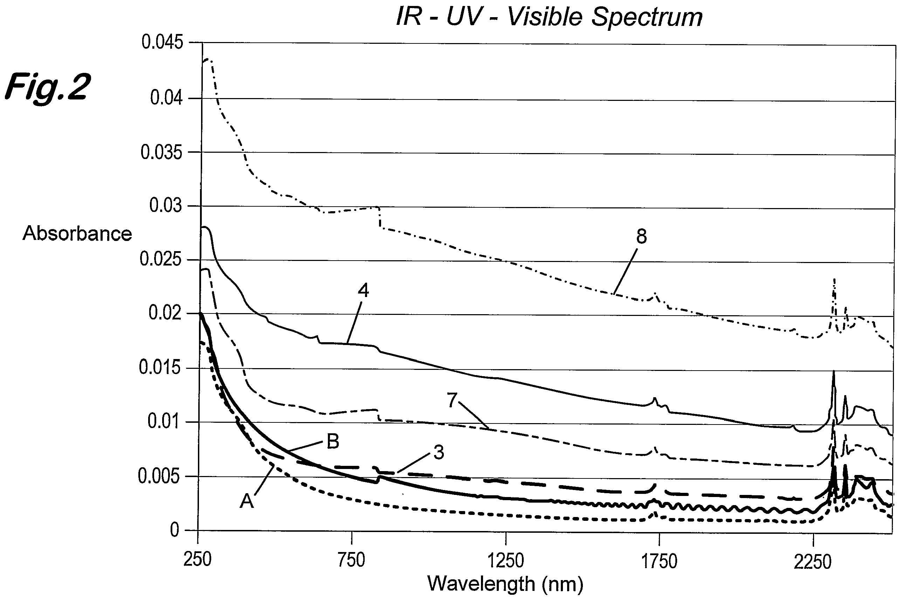

The invention will now be described in more detail, with reference to Figures 1 and 2, which show plots of the degree of radiation absorption against wavelength for the films and tapes prepared in the Examples below.

### EXAMPLE 1 (reference)

70% by weight of an ethylene/butene copolymer ELTEX® (available from Solvay Polyolefins Europe-Belgium SA) was compounded together with 30% by weight of the pigment IRIODIN® SHR 9875 (available from Merck KGaA) to form pellets. IRIODIN® SHR 9875 contains pigment particles of mica, titanium dioxide, tin dioxide and zirconium dioxide 5-25µm in size, and reflects purple light and transmits green light. These pellets were then incorporated with ELTEX® A5006FN1280 high density polyethylene at a weight ratio of 1:14 during extrusion, to give a final polymer containing 2 wt% of pigment, which was extruded into a film.

### EXAMPLE 2

Example 1 was repeated, except that the final film containing 2 wt% pigment was slit into tapes and then stretched in an oven at 110°C to 7 times its original length.

### EXAMPLE 3 (reference)

Example 1 was repeated, except that the pigment used was IRIODIN® SHR 9870, in which the particle size is 10-60 µm.

### EXAMPLE 4

Example 3 was repeated, except that the final film containing 2 wt% pigment was slit into tapes and then stretched 7 times, and then slit into tapes.

### Example 5 and 7 (reference) and Example 6 and 8

Examples 1 to 4 were repeated, except that the level of pigment in each case was 4 wt%.

### Example 9 (reference) and Example 10

Examples 1 and 2 were repeated, except that the level of pigment in each case was 8 wt%.

The absorbency per unit length of the above films and tapes was then measured with a Shimadzu UV-3101PC spectrometer. The results of these measurements are shown in Figures 1 and 2, which indicate plots degree of absorption against wavelength.

The various lines shown absorption spectra for the following:
Figure 1
   A - unstretched ELTEX® A5006FN/1280 film with no pigment
   B - stretched ELTEX® A5006FN/1280 tape with no pigment
   1 - Example 1 (unstretched ELTEX® A5006FN/1280 film with 2 wt% IRIODIN® SHR 9875 pigment)
   2 - Example 2 (stretched ELTEX® A5006FN/1280 tape with 2 wt% IRIODIN® SHR 9875 pigment)
   5 - Example 5 (unstretched ELTEX® A5006FN/1280 film with 4 wt% IRIODIN® SHR 9875 pigment)
   6 - Example 6 (stretched ELTEX® A5006FN/1280 tape with 4 wt% IRIODIN® SHR 9875 pigment)
   9 - Example 9 (unstretched ELTEX® A5006FN/1280 film with 8 wt% IRIODIN® SHR 9875 pigment)
   10 - Example 10 (stretched ELTEX® A5006FN/1280 tape with 8 wt% IRIODIN® SHR 9875 pigment)
Figure 2
   A - unstretched ELTEX® A5006FN/1280 film with no pigment
   B - stretched ELTEX® A5006FN/1280 tape with no pigment
   3 - Example 3 (unstretched ELTEX® A5006FN/1280 film with 2 wt% IRIODIN® SHR 9870 pigment)
   4 - Example 4 (stretched ELTEX® A5006FN/1280 tape with 2 wt% IRIODIN® SHR 9870 pigment)
   7 - Example 7 (unstretched ELTEX® A5006FN/1280 film with 4 wt% IRIODIN® SHR 9870 pigment)
   8 - Example 8 (stretched ELTEX® A5006FN/1280 tape with 4 wt% IRIODIN® SHR 9870 pigment)

A comparison of Examples 1 and 2 in Figures 1 shows that the stretched tapes containing IRIODIN® SHR 9875 absorb approximately three times as much radiation as the unstretched film when the pigment concentration is 2 wt%. At higher pigment concentrations (Examples 5 and 6 or 9 and 10) the relative increase in absorption after stretching is less, but still significant. A similar effect is shown in Figure 2 for IRIODIN® SHR 9870, comparing Examples 3 and 4 or 7 and 8.

## Claims

1. Process for the production of a composition for screening solar radiation which comprises a transparent polymer incorporating an interference pigment comprising a platelet shaped material, which process comprises the steps of incorporating the interference pigment into the polymer, stretching the resultant polymer in at least one direction to at least twice its original length in that direction, and then converting the polymer into a woven net of tapes or monofilaments.

2. Process according to claim 1, wherein the degree of stretching of the polymer is at least 4 times its original length.

3. Process according to claim 1 or 2, wherein the degree of stretching of the polymer is from 6 to 10 times its original length.

4. Process according to any preceding claim, wherein the interference pigment is green and comprises a layered silicate, synthetic mica, glass platelets, ceramic platelets or silica platelets.

5. Process according claim 4, wherein the layered silicate is mica, pyrophillite, sericite, talc or kaolin.

6. Process according to any preceding claim, wherein after stretching the polymer has a thickness of less than 30µm.

## Patentansprüche

1. Verfahren zur Herstellung einer Zusammensetzung zum Abschirmen von Sonnenstrahlung, welche ein transparentes Polymer umfasst, in das ein Interferenzpigment eingebaut ist, welches ein plättchenförmiges Material umfasst, wobei das Verfahren die Schritte des Einbauens des Interferenzpigments in das Polymer, Strecken des resultierenden Polymers in mindestens eine Richtung auf mindestens das Doppelte seiner ursprünglichen Länge in jener Richtung, und nachfolgendes Umwandeln des Polymers in ein gewebtes Netz aus Bändern oder Monofilamenten umfasst.

2. Verfahren nach Anspruch 1, wobei der Grad des Streckens des Polymers mindestens das 4-fache seiner ursprünglichen Länge ist.

3. Verfahren nach Anspruch 1 oder 2, wobei der Grad des Streckens des Polymers mindestens das 6- bis 10-fache seiner ursprünglichen Länge ist.

4. Verfahren nach einem der vorhergehenden Ansprüche, wobei das Interferenzpigment grün ist und ein Schichtsilikat, synthetischen Glimmer, Glasplättchen, Keramikplättchen oder Siliciumdioxidplättchen umfasst.

5. Verfahren nach Anspruch 4, wobei das Schichtsilikat Glimmer, Pyrophillit, Sericit, Talkum oder Kaolin ist.

6. Verfahren nach einem der vorhergehenden Ansprüche, wobei das Polymer nach dem Strecken eine Dicke von weniger als 30 µm aufweist.

## Revendications

1. Procédé de fabrication d'une composition faisant écran au rayonnement solaire qui comprend un polymère transparent contenant un pigment d'interférence comprenant un matériau en forme de plaquettes, le procédé comprenant les étapes d'incorporation du pigment d'interférence dans le polymère, d'étirage du polymère obtenu dans au moins une direction jusqu'à au moins 2 fois sa longueur d'origine dans cette direction, puis la conversion du polymère en un filet tissé de rubans ou de monofilaments.

2. Procédé selon la revendication 1, dans lequel le degré d'étirage du polymère est d'au moins 4 fois sa longueur d'origine.

3. Procédé selon la revendication 1 ou 2, dans lequel le degré d'étirage du polymère est de 6 à 10 fois sa longueur d'origine.

4. Procédé selon l'une quelconque des revendications précédentes, dans lequel le pigment d'interférence est vert et comprend un silicate stratifié, un mica synthétique, des plaquettes de verre, des plaquettes de céramique ou des plaquettes de silice.

5. Procédé selon la revendication 4, dans lequel le silicate stratifié est le mica, la pyrophillite, la séricite, le talc ou le kaolin.

6. Procédé selon l'une quelconque des revendications précédentes, dans lequel, après l'étirage, le polymère a une épaisseur inférieure à 30 µm.
